# EUROPEAN PATENT APPLICATION

(11) **EP 4 769 407 A1**
(43) Date of publication of application: **01.07.2026**
(21) Application number: 24223216.3
(22) Date of filing: 24.12.2024
(51) Int. Cl.: G11C 11/22

(54) **SPIN-ORBIT FERROELECTRIC MEMORY CELLS AND MATRIX FOR MEMORY, AI AND IMC APPLICATIONS**

(71) Applicant: Commissariat à l'Energie Atomique et aux Energies Alternatives, 75015 Paris (FR); Centre National de la Recherche Scientifique, 75016 Paris (FR); Université Grenoble Alpes, 38400 Saint-Martin-d'Hères (FR); Institut Polytechnique de Grenoble, 38000 Grenoble (FR)
(72) Inventor: SGARRO, Paolo, Grenoble, 38054 (FR); PRENAT, Guillaume, Grenoble, 38054 (FR); VILA, Laurent, Grenoble, 38054 (FR); ATTANE, Jean-Philippe, Grenoble, 38054 (FR); KANDAZOGLOU, Aurélie, Grenoble, 38054 (FR); TERESI, Salvatore, Grenoble, 38054 (FR); CULOT, Maxime, Grenoble, 38054 (FR); FROTTIER, Théo, Grenoble, 38054 (FR); OSANA, Filip, Grenoble, 38054 (FR)
(74) Representative: Cabinet Camus Lebkiri

(57) **Abstract**

The invention has for object a memory cell (100) comprising a spin-orbit ferroelectric memory (110) comprising a first, second and third terminals (121, 122, 123), the memory (110) having a spontaneous electrical polarisation able to adopt two distinct states, the first, second, and third terminals (121, 122, 123) being connected to the memory in a way that a first charge current flows (11) in the second terminal (122) when a voltage is applied between the first and third terminals (121, 123), the amplitude and sign of the charge current being function of the voltage applied between the first and third terminals (121, 123) and function of the spontaneous electrical polarisation. The cell (100) comprises an isolation component (130) connected to the second terminal (122) and configured to prevent charge currents from flowing in the second terminal (122) towards the memory (110) when no voltage is applied between the first and third terminals (121, 123) and to allow charge currents to flow in the second terminal and from the memory when a voltage is applied between the first and third terminals (121, 123).

## Description

### TECHNICAL DOMAIN

The technical domain of the invention is related to information storage and especially memory cells based on spin-orbit ferroelectric memories and matrix of such memory cells.

### PRIOR ART

Several microelectronics memories have been proposed to store information in a non-volatile way, such as magnetic memories, ferroelectric memories and phase change memories. Each of them shows different performances in terms of speed, endurance, reliability, and density. One of these alternatives are the spin-orbit ferroelectric memories. Such memories are described in FR3091412B1 and FR3126085A1. Spin-orbit ferroelectric memories comprise a ferroelectric component and a spin-orbit coupling component. The ferroelectric component has a spontaneous electrical polarisation which can be used to store an information. The spin-orbit coupling component is configured to be influenced by the spontaneous electrical polarisation of the ferroelectric component. This way, the spin-orbit coupling component can convert a charge current function of the spontaneous electrical polarisation.

Connecting such spin-orbit ferroelectric memories in matrix, especially large arrays, tends to erase the information stored in the different memories. Therefore, it exists a need to provide a way to connect easily such memories in a matrix with a reduced risk of information erasing.

### SUMMARY

The invention solves the above-mentioned problem by embedding a spin-orbit ferroelectric memory within a memory cell that provides a way to isolate the output of the memory.

To do so, the invention concerns a memory cell comprising : a spin-orbit ferroelectric memory comprising at least a first terminal, a second terminal, and a third terminal, the spin-orbit ferroelectric memory having a spontaneous electrical polarisation being able to adopt at least two distinct states, the first, second, and third terminals being connected to the spin-orbit ferroelectric memory in a way that a first charge current flows in the second terminal when a voltage is applied between the first and third terminals, the amplitude and sign of the charge current being function of the voltage applied between the first and third terminals and function of the spontaneous electrical polarisation, the memory cell comprising an isolation component connected to the second terminal and configured to:
- prevent charge currents from flowing in the second terminal towards the spin-orbit ferroelectric memory when no voltage is applied between the first and third terminals; and
- allow charge currents to flow in the second terminal and from the spin-orbit ferroelectric memory when a voltage is applied between the first and third terminals.

An information can be stored in the memory cell thanks to the spontaneous electrical polarisation. Measuring the first charge current while the spin-orbit ferroelectric memory is biased (a voltage being applied on the spin-orbit ferroelectric memory, especially between the first and third terminals) allows to probe the state of the electrical polarisation. This way, the second terminal forms an output of the memory cell.

The isolation component provides a way to block charge currents coming from other sources (also called "backflow currents") when the spin-orbit ferroelectric memory is not biased. Those backflow currents cannot act on the spontaneous electrical polarisation to change its state. This way, the memory cell keeps its information safe. Moreover, multiple memory cells according to the invention can be connected to a common conducting line, for example in a matrix, without allowing backflow currents from said line to interfere with the spin-orbit ferroelectric memory and change its state.

Beneficially, the isolation component comprises a diode having an anode connected to the second terminal.

Beneficially, the isolation component comprises a transistor connected to the second terminal, said transistor having a channel and a gate, said channel being connected to the second terminal and said gate being connected to the first terminal in a way to:
- block the channel of the transistor of the isolation component connected to the second terminal when no voltage is applied between the first and third terminals; and
- open the channel of the transistor of the isolation component connected to the second terminal when the voltage is applied between the first and third terminals.

Beneficially, the memory cell comprises a fourth terminal connected to the spin-orbit ferroelectric memory in a way that a second charge current flows in the fourth terminal when a voltage is applied between the first and third terminals, the amplitude and sign of the charge current being function of the voltage applied between the first and third terminals and function of the spontaneous electrical polarisation, the sign of the second charge current being opposite to the sign of the first charge current, the isolation component being further configured to:
- prevent charge currents from flowing in the fourth terminal towards the spin-orbit ferroelectric memory when no voltage is applied between the first and third terminals; and
- allow charge currents to flow in the fourth terminal and from the spin-orbit ferroelectric memory when the voltage is applied between the first and third terminals.

Beneficially, the isolation component comprises a diode having an anode connected to the fourth terminal.

Beneficially, the isolation component comprises a transistor connected to the fourth terminal, said transistor having a channel and a gate, said channel being connected to the fourth terminal and said gate being connected to the first terminal in a way to:
- block the channel of the transistor of the isolation component connected to the fourth terminal when no voltage is applied between the first and third terminals; and
- open the channel of the transistor of the isolation component connected to the fourth terminal when a voltage is applied between the first and third terminals.

Beneficially, the memory cell comprises a bias circuit connected to the first and third terminals, the bias circuit comprising a transistor having a channel and a gate, said channel being connected to the first terminal.

Beneficially, the gate of the transistor of the bias circuit is connected to the gate of the transistor of the isolation component connected to the second terminal.

Beneficially, the gate of the transistor of the bias circuit is connected to the gate of the transistor of the isolation component connected to the fourth terminal.

Beneficially, the spin-orbit ferroelectric memory comprises a ferroelectric component, and the memory cell comprises an additional terminal, the ferroelectric component carrying the spontaneous electrical polarisation, the additional terminal being connected to the spin-orbit ferroelectric memory in a way that a voltage applied between the first terminal and the fifth terminal applies an electrical field on the ferroelectric component, the memory cell further comprising a resistance connected in parallel between the first terminal and the fifth terminal.

Beneficially, the spin-orbit ferroelectric memory comprises:
- a spin-orbit ferroelectric element, carrying the spontaneous electrical polarisation; and
- a spin polarisation element,
the spin polarisation element being connected between the first and third terminals and configured to generate a spin polarised current when the voltage is applied between the first and third terminals, the spin-orbit ferroelectric element being connected between the second and third terminals and being configured to convert the spin polarised current issued from the spin polarisation element into the charge current flowing in the second terminal, the conversion being performed with a conversion rate and/or a conversion sign, said conversion rate and/or conversion sign being function of the spontaneous electrical polarisation.

Beneficially, the spin-orbit ferroelectric element comprises:
- a ferroelectric layer carrying the spontaneous electrical polarisation; and
- a spin-orbit layer in direct contact with the ferroelectric layer.

The invention further concerns a matrix according to claim 13, further comprising:
- a plurality of first conducting lines, called "source lines";
- a plurality of second conducting lines, called "word lines"; and
- a plurality of third conducting lines, called "bit lines",
each memory cell being connected to a source line of the plurality of source lines, a word line of the plurality of word lines, and a bit line of the plurality of bit lines, for each memory cell, the isolation component of said memory cell is connected between the second terminal of said memory cell and the bit line connected to said memory cell.

Beneficially, each memory cell is a memory cell according to any of claims 7 to 9, and wherein, for each memory cell, the channel of the transistor of the bias circuit of said memory cell is connected to the source line connected to said memory cell, and the gate of the transistor of the bias circuit of said memory cell is connected to the word line connected to said memory cell.

Beneficially, the matrix further comprising a plurality of fourth conducting lines, called "complementary bit lines", and wherein each memory cell is a memory cell according to claims 4 to 6 or to claim 9, and wherein, for each memory cell, the fourth terminal of said memory cell is connected to a complementary bit line of the plurality of complementary bit lines, and wherein, for each memory cell, the isolation component of said memory cell is connected between the fourth terminal of said memory cell and the complementary bit line connected to said memory cell.

The invention and its various applications will be better understood on reading the following description and examining the accompanying figures.

### BRIEF DESCRIPTION OF THE FIGURES

Unless otherwise specified, the same element appearing on different figures has a unique reference. The figures are presented for information only and are by no means restrictive of the invention.
Figs. 1 to 4 schematically show four embodiments of a spin-orbit ferroelectric memory as implemented in the invention.
Figs. 5 to 8 show four examples of spin-orbit ferroelectric memories, each example corresponding to the embodiments of the spin-orbit ferroelectric memories of Figs. 1 to 4.
Figs. 9 to 20 show twelve examples of a memory cell according to the invention.
Figs. 21 and 22 show two examples of a unit logic that can be implemented in a matrix of memory cells according to the invention.
Figs. 23 to 24 show four examples of a matrix of memory cells according to the invention.
Figs. 27 shows an example of operation of the matrix according to Fig. 24.

### DETAILED DESCRIPTION

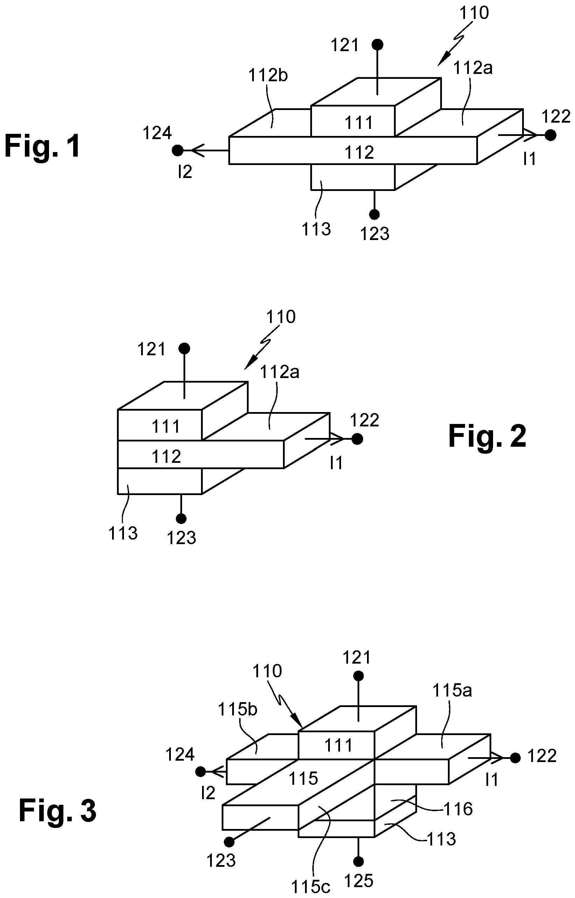

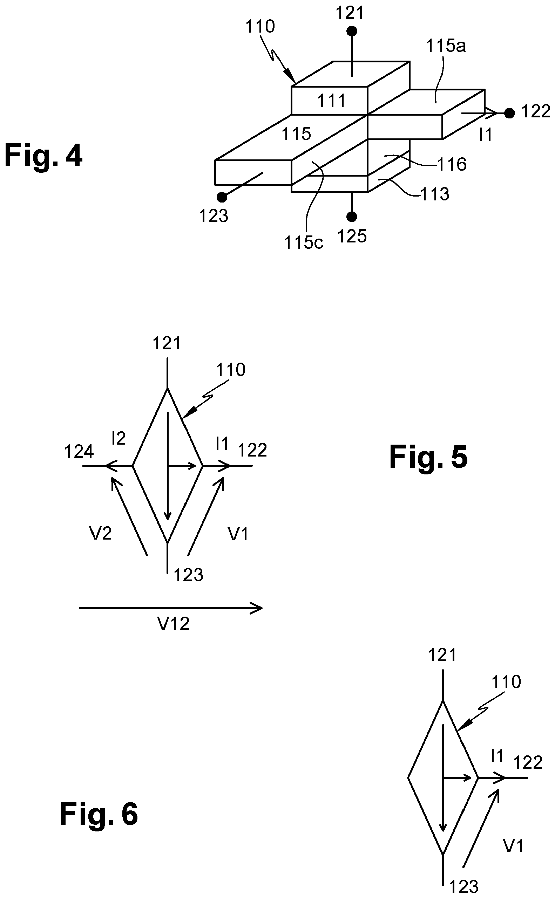

Figs. 1 to 4 show four examples of spin-orbit ferroelectric memories 110 also called "SOF memories". Each of those examples correspond to one of the schematic representation of Figs. 5 to 8.

A SOF memory 110 relies on a ferroelectric effect, a spin-orbit effect and a coupling between both. It allows to store an information thanks to the ferroelectric effect and read said information thanks to the spin-orbit effect and its coupling with the ferroelectric effect. A SOF memory 110 possesses advantages with respect to competing alternatives such as magnetic memories, ferroelectric field effect transistors or phase change memories. For example, it requires a lower energy to set commute between stable states. It also allows to read said state in a non-destructive way. It further exhibits a larger endurance than some memories such as the phase change memory.

Thanks to its ferroelectric effect, the SOF memory 110 exhibits a spontaneous electrical polarisation. This polarisation can adopt at least two stable and distinct states. By state, is meant an orientation and/or an amplitude of the spontaneous electrical polarisation. This way, at least a multiple state information (such as a binary information) can be stored with the SOF memory 110. In an embodiment, the polarisation can adopt strictly more than two distinct states and allows to store multiple states information (for example ternary or quaternary information). In another embodiment, it can adopt so many stable states that it forms a continuum of states (it means a continuous range of stable states). This embodiment can allow to store an information that can exhibits a state within a range, such as an analogous information (for example a normalized temperature).

The SOF memory 110 also relies on spin-orbit effect and its coupling with the ferroelectric effect. Spin-orbit effect, such as inverse Rashba effect or inverse Edelstein effect, allows to convert a longitudinal spin current into a transverse charge current. It performs such conversion with a conversion rate and/or a conversion sign. By conversion rate, it is understood the rate of the amplitude of the transverse charge current over the amplitude of the longitudinal spin current. The coupling between the spin-orbit effect and the ferroelectric effect modifies the conversion rate and/or the conversion sign as a function of the spontaneous electrical polarisation of the SOF memory 110. For different state of the spontaneous electrical polarisation correspond different conversion rate and/or the conversion sign. Therefore, measuring a variation in the transverse charge current outputted by the SOF memory 110 allows to probe the state in which the spontaneous polarisation is.

Another technology for which SOF memory can be exploited is for Content Addressable Memories (also known as "CAM"). In this kind of memory, used for fast search purposes, the information saved in the memory is compared with the input, containing the information sought. This allows to search data in a full matrix during one clock cycle giving, as search result, the address of the word equal to the sought one. As an input is applied, the result at the output must depend on the comparison between the input and the information stored. In Ternary Content Addressable memories (known as "TCAMs"), three possible states are possible for the memory cell: 0, 1 and X (or don't care) leading to two different outputs: "match" and "not match", where the X gives a match for any encoded state.

A Spin-Orbit Ferroelectric Content Addressable Memory (said "SOFCAM") can be implemented by considering that two inputs with opposite sign, will lead, for the same information encoded, two outputs of opposite sign, that will correspond to a match or a not match.

A Spin-Orbit ferroelectric Ternary Content Addressable Memory (said "SoFTCAM") cell can be implemented connecting with two SoF memories 110, whose output pins are connected together, and in which the three different combinations of states are used to represent 0, 1 and X. For example, the two antisymmetric states (which correspond to different polarisation within the memory cell) can be used as 1 and 0 and a symmetric state can be used as a X. Sending two opposite inputs to the two SoF memories 110, the output, being the average of the two, can have three intermediate values. With the proper reading strategy, i.e. tuning a baseline of the output with the threshold voltage of a transistor, the cell can operate as a SoFTCAM with large density.

Figs. 1 to 4 show four examples of a SOF memories 110 that can be implemented in the memory cell 100 according to the invention.

In the Figs. 1 and 2, the SOF memories comprise a spin-orbit ferroelectric layer 112 (also called "SOF layer"). It is, in those examples, a conducting or semiconducting layer, allowing charge currents to flow in the layer 112. The layer 112 is lying in a plane (not shown) forming a "plane of the layer". The spin-orbit ferroelectric layer 112 exhibits both a high spin-orbit coupling and a spontaneous electrical polarisation. A high spin-orbit coupling is, for example, higher that 1.36 eV (which corresponds to 0.1 Ry) or higher than 13.6 eV (which corresponds to 1 Ry), even higher than 136 eV (which corresponds to 10 Ry). The spin-orbit ferroelectric layer 112 carries a spontaneous electrical polarisation. For example, it comprises a ferroelectric domain that exhibits the spontaneous electrical polarisation.

The spontaneous electrical polarisation can adopt at least two distinct stable states. "Stable state" means a stable orientation of the polarisation and/or stable amplitude of the polarisation. The stable states can correspond to two distinct orientations of the polarisation, for example, orientations perpendicular to the spin layer 112 (for example perpendicular to the plan of the layer) with opposite directions. Each stable state can correspond to a state of an information to be stored in the memory cell 110. In a development, the spontaneous electrical polarisation can adopt more that two stable states, even a continuum of stable states.

The SOF memory 110 comprises a spin polarisation layer 111. It is configured to convert a charge current to a spin polarised current. It can be in direct contact with the spin-orbit ferroelectric layer 112 to directly inject the spin polarised current in the spin-orbit ferroelectric layer 112. The SOF memory 110 can also comprise a conducting spacer between the spin polarisation component 111 and the spin-orbit ferroelectric layer 112. This conducting spacer allows the spin polarised current to flow from the spin polarisation layer 111 to the spin-orbit ferroelectric layer 112. The spin polarisation layer 111 is, for example, made of a ferromagnetic material.

The SOF memory 110 also comprises a conducting layer 113, for example made of metal. When the spin-polarisation layer 111 is arranged on a first side of the spin-orbit ferroelectric layer 112, the conducting layer 113 is arranged on the other side of the spin-orbit ferroelectric layer 112, with respect to the plan of the layers. The conducting layer 113 is preferably aligned with the spin polarisation layer 111 (below in the Figs. 1 and 2) to form a stack of layers. A first part 112a of the spin-orbit ferroelectric layer 112 extends out of the stack to form a first branch. In Fig. 1 only, a second part 112b of the spin-orbit ferroelectric layer 112 extends out of the stack, in the opposite direction with respect to the first branch 112a, to form a second branch.

This way, applying a voltage between the spin-polarisation layer 111 and the conducting layer 113 induces a charge current flowing in a perpendicular direction with respect to the plane of the layers. Said charge current is converted into a spin polarised current by the spin polarisation layer 111. The resulting spin polarised current flows in the spin-orbit ferroelectric layer 112, perpendicularly to this plane of the layer, and is converted by the spin-orbit ferroelectric layer 112 in a charge current flowing parallel to the plane of the layers, for example in the first branch 112a of the spin-orbit ferroelectric layer 112.

The charge current generated by the spin-orbit ferroelectric layer 112 can be measured by measuring the current flowing in the first branch 112a and in the second branch 112b, or by measuring a bias voltage between the first branch 112a of the spin-orbit ferroelectric layer 112 and the conducting layer 113, or by measuring a bias voltage between the first and second branches 112a, 112b of the spin-orbit ferroelectric layer 112 (in the case of Fig. 1).

Figs. 3 and 4 differs from Figs. 1 and 2 in that the spin-orbit ferroelectric layer 112 is split into two distinct layers 115, 116 : the first layer 115 is a spin-orbit layer (also called "SO layer") and the second layer 116 is a ferroelectric layer. The spin-orbit layer 115 and the ferroelectric layer 116 are in direct contact or spaced by a conducting spacer. The spin-orbit layer 115 is arranged between the ferroelectric layer 116 and the spin polarisation layer 111. Preferably, the spin polarisation layer 111 is in direct contact with the spin-orbit layer 115. The ferroelectric layer 116 is arranged between the spin-orbit layer 115 and the conducting layer 113.

The spin-orbit layer 115 does not exhibit any spontaneous electrical polarisation. Or if it does, said polarisation is too weak to be considered to store an information or to influence its spin/charge conversion rate. The spin-orbit layer 115 is preferably conducting or semiconducting. The ferroelectric layer is preferably insulating but it can also be semiconducting or conducting.

The spin-orbit layer 115 is lying in the plane of the layers. It shows at least two parts 115a, 115b extending out of the stack, in opposite direction, to form a first branch and a second branch. In Fig. 3 only, the spin-orbit layer 115 comprises a third part 115c extending out of the stack, parallel to the plane of the layers and perpendicularly to the two first branches 115a, 115b, to form a third branch 115c.

The spin-orbit layer 115 is preferably in a direct contact with the spin polarisation layer 111. It can be in a direct contact with the ferroelectric layer 116. It can also be spaced from the ferroelectric layer 116 by an insulating spacer. In such a case, the thickness of the insulating spacer should be low enough so that the conversion rate and/or conversion sign of the spin-orbit layer 115 is still function of the spontaneous electrical polarisation of the ferroelectric layer 116. No current is expected to flow through the ferroelectric layer 116 since it is insulating and has a large resistance. A control of the spontaneous electrical polarisation can by performed by applying an electrical field. The ferroelectric layer 116 can be in direct contact with the conducting later 113 or spaced from it by an insulating spacer. The thickness of the spacer should not be too high to get a high electrical field on the ferroelectric layer 116.

The charge current generated by the spin-orbit layer 115 can be measured in the first and/or second branches 115a, 115b or by measuring the bias voltage between the first branch 115a and the third branch 115c of the spin-orbit layer 115 or between the first and second branches 115a, 115b of the spin-orbit layer 115.

The SOF memory 110 comprises at least three terminals 121, 122, 123. The terminals 121, 122, 123 are, for example, conducting wires routed to different points of the SOF memory 110.

The first terminal 121 is, for example, connected to the spin-polarisation layer 111. The second terminal 122 is, for example, connected to the first branch 112a of the spin-orbit ferroelectric layer 112 of the Figs. 1 and 2, or to the first branch 115a of the spin-orbit layer 115 of Figs. 3 and 4. The third terminal 123 is, for example, connected to the conducting layer 113 for the memory 110 of the Figs. 1 and 2, and to the third branch 115c of the spin-orbit layer 115 for the memory 110 of the Figs. 3 and 4.

A voltage applied between the first terminal 121 and the third terminal 123 induces:
- an application of an electrical field on the spin-orbit ferroelectric layer 112 (only in the embodiments of Figs. 1 and 2); and
- a current flowing through the spin polarisation layer 111 which generates (or is converted in) a spin current flowing in the spin-orbit ferroelectric layer 112 (in Figs. 1 and 2) or in the spin-orbit layer 115 (in Figs. 3 and 4).

The spin current is then converted into a transverse charge current by the the spin-orbit ferroelectric layer 112 (in Figs. 1 and 2) or in the spin-orbit layer 115 (in Figs. 3 and 4), which flows in the second terminal 122.

A low voltage applied between the first and third terminals 121, 123 will apply a low electrical field on the spin-orbit ferroelectric layer 112 (in Figs. 1 and 2) or on the ferroelectric layer 116 (in Figs. 3 and 4). It will not change the state of the spontaneous electrical polarisation. However, because of the spin current converted in a transverse charge current in the spin-orbit ferroelectric layer 112 (in Figs. 1 and 2) or in the spin-orbit layer 115 (in Figs. 3 and 4), a first charge current I1 is outputat the second terminal 122. Measuring this first charge current I1 allows to probe the state of the spontaneous electrical polarisation. In other words, it allows to perform a reading of the state of the spontaneous electrical polarisation.

The first charge current I1 is proportional to the voltage drop V1 between the second and third terminals 122, 123. The amplitude and/or the sign of the voltage drop V1 give a way to probe the state of the electrical polarisation.

In the examples of the Figs. 1 and 3, the SOF memory 110 comprises a fourth terminal 124, connected to the second branch 112b of the spin-orbit ferroelectric layer 112 of the memory of Fig. 1, and connected to the second branch 115b of the spin-orbit layer 115 of the memory of Fig. 3. Because of the spin current converted in a transverse charge current in the spin-orbit ferroelectric layer 112 (in Figs. 1 and 2) or in the spin-orbit layer 115 (in Figs. 3 and 4), a second charge current I2 is output, as well as the first charge current I2. However, this second charge current I2 has a sign opposite to the sign of the first charge current 11.

Another voltage drop V12, between the second and fourth terminals 122, 124 is proportional to I1 + I2. The amplitude and/or the sign of this other voltage drop V12 can also give a way to probe the state of the electrical polarisation.

A high voltage applied between the first and third terminal 121, 123 of Figs. 1 or 2 applies a strong electrical field on the spin-orbit ferroelectric layer 112 and can commute its spontaneous polarisation from a stable state to another stable state. In other words, applying a high voltage between the first and third terminal 121, 123 of Figs. 1 or 2 will write an information in the SOF memory 110.

In the case of Figs. 1 and 2, because the spin-orbit ferroelectric layer 112 is conductive and because the terminals used to perform a reading are the same as the ones to perform a writing, it generates a spin polarised current the spin-orbit ferroelectric layer 112 and therefore it generates a first charge current I1 at the second terminal 122 and a second charge current I1 at the fourth terminal 124, if applicable. Therefore, it is possible to measure the charge currents flowing in the second terminal 122 and/or the fourth terminal 124.

The difference between low and high voltage lies in the ability to write or not a state in the SOF memory 110. It depends on the electrical anisotropy of the electrical polarisation, the temperature considered, as well as the information lifetime expected. One may expect a low variation of the information even with a high number of readings of the memory. A skilled person in field of spin-orbit ferroelectric memories is able to measure the data retention against a number of readings of the memory cell 110 and define low threshold and high threshold for, respectively, high and low voltages.

In the examples of the Figs. 3 and 4, a fifth terminal is connected to the conducting layer 113. This terminal 125 is also called "writing terminal" or "body contact". It is involved, with the first terminal 121, to write an information in the ferroelectric layer 116.

Applying a high voltage between the first and fifth terminal 121, 125 of Figs. 3 or 4 applies an electrical field on the ferroelectric layer 116 and can commute its spontaneous polarisation from a stable state to another. In other words, applying a voltage between the first and fifth terminals 121, 125 will write an information in the SOF memory 110.

The current path to read and write are distinct in this case. Therefore the amplitude of the voltages applied between the first and fifth terminals 121, 125 and the first and third terminals 121, 123 are less relevant. However, a skilled person in field of spin-orbit ferroelectric memories is able to measure the information lifetime against a number of readings of the memory cell 110 and define a high threshold for the voltage to apply to perform a reading (it means between the first and third terminals 121, 123).

A current flowing in the second terminal 122, back to the spin-orbit ferroelectric layer 112 or back to the spin-orbit layer 115, also known as "backflow current", can interfere with the spontaneous polarisation of the ferroelectric layers 112, 115. In the case of the Figs. 1 and 2, the backflow current can create an electrical field within the spin-orbit ferroelectric layer 112 and act on the spontaneous polarisation. In the case of the Figs. 3 and 4, the backflow current can apply a voltage between the spin-orbit layer 115 and the conductive layer 113. This voltage can apply an electrical field on the spontaneous polarisation of ferroelectric layers 115. Therefore, the backflow currents can reduce drastically the information lifetime of the memory cell 110. The purpose of the invention is to isolate the memory cell 110 from backflow currents.

Figs. 5 to 8 schematically show diagrams of the SOF memories 110 respectively corresponding to the SOF memories of Figs. 1 to 4. Only the terminals 121, 122, 123, 124, 125 are shown. The diamond-like shape corresponds to the SOF memory 110. The corresponding example among Figs. 1 to 4 can be deduced from the number of terminals involved. The vertical arrow in the diamond-like shape (with respect to the sheet) represents the direction of the spin polarised current flowing from the first to the third terminal 121, 123 when a voltage is applied between the first and third terminals 121, 123. The horizontal arrow in the diamond-like shape, pointing to the left in the figures, represents the direction of the transverse charge current flowing out of the SOF memory 110 when a positive spin-orbit effect is involved ("positive effect" for example meaning an inverse Rashba effect with a positive spin-orbit coupling).

The first charge current I1 is measured in the second terminal 122. The corresponding first voltage drop V1, also called "first reading voltage", is measured between the second and third terminals 122, 123. The second charge current I2, if applicable, is measured in the fourth terminal 124. The corresponding second voltage drop V2, also called "second reading voltage", is measured between the fourth and third terminals 124, 123. Regarding both first and second reading voltage V1, V2, the third terminal 123 is considered as the zero potential or ground potential. A transverse reading voltage V12 can be measured between the second and fourth terminal 122, 124. It corresponds to V12 = V1 - V2.

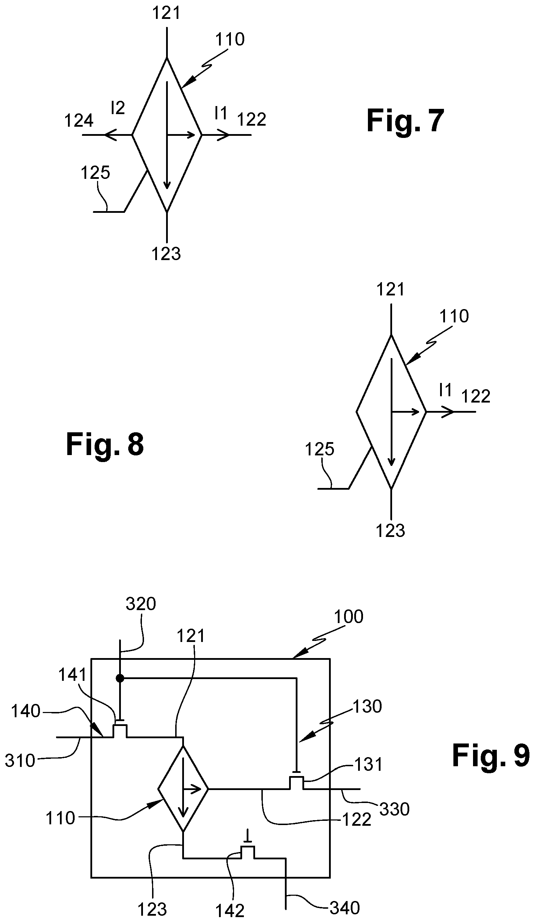

Fig. 9 shows a first embodiment of a memory cell 100 according to the invention. In this embodiment the memory cell 100 comprises four pins 310, 320, 330, 350 that can be used to connect the memory cell 100 to its environment, such as a matrix of memories for example. The first, second and fourth pins 310, 320, 340 are intended to be connected to voltage sources, to control the polarisation of the memory cell 110 to write an information or read the information stored. The third pin 330 is intended to be connected to a measurement devices to measure the current outputted and/or the voltage drop against the fourth pin 340. The third pin 330 is thus involved in the reading of the information stored in the memory cell 110.

The memory cell 100 comprises a SOF memory 110 whose role is to carry the information stored in the memory cell. In the Fig. 9, it comprises a SOF memory according to Figs. 6 or 8 which corresponds to the example of Figs. 2 and 4. In this embodiment, the SOF memory 110 implemented only comprises three terminals.

The memory cell 100 comprises a bias circuit 140 which comprises a first transistor 141 and a second transistor 142, respectively called "first bias transistor" and "second bias transistor". The first and second bias transistors 141, 142 can be field effect transistors (also called "FET") or bipolar transistors. They can be of the same type or of different types. Each of them comprises a channel and a gate to control the conductivity of said channel. The terms "open" and "closed" are used to respectively define a high conductivity (wherein the channel is preferably fully conductive) and a low conductivity (wherein the channel is preferably not conductive). The channel of the first bias transistor 141 is connected, on one side, to the first terminal 121 of the SOF memory 110 and, on the other side, to a first pin 310. The channel of the second bias transistor 142 is connected, on one side, to the third terminal 123, and on the other, to a fourth pin 340. This way, when the channels of the first and second bias transistors 141, 142 are opened, a voltage applied between the first and fourth pins 310, 340 will apply a voltage on the first and third terminals 121, 123 of the SOF memory 110 (in other word, the SOF memory 110 is biased according to the sign of the voltage applied).

Blocking the channel of the first and/or second bias transistor 141, 142 results in blocking any application of a voltage on the SOF memory 110. The SOF memory 110 is therefore not biased. The gate of the first bias transistor 141 is connected to the second pin 320. The first bias transistor 141 can, therefore, be controlled by applying a voltage to the second pin 320. Therefore, the electrical biasing of the SOF memory 110 can be controlled using the second pin 320. Regarding the second bias transistor 142, its gate can also be controlled using the second pin 320 and can, for example, be connected to said second pin 320.

The memory cell 100 further comprises an isolation component 130 whose role is to prevent electrical currents to flow from the third pin 330 to the SOF memory 110 and accidentally induce its erasing. Electrical currents that flow from the third pin 330 to the SOF memory 110 are called "backflow currents". To prevent this risk, the memory cell 100 is configured to isolate the SOF memory 110 from backflow currents when it is not biased. To do so, the isolation component 130 is connected between the second terminal 122 of the SOF memory 110 and the third pin 330. It is, at least, configured to block any backflow current coming from the third pin 330 when the SOF memory is not biased. It is further configured to allow a current coming from the SOF memory 110 to flow to the third pin 330 when the SOF memory 110 is biased. This way, the SOF memory 110 is only connected to the third pin 330 when it needs to.

According to different embodiments, the isolation component 130 can further be configured to allow or block the current coming from the SOF memory 110 to flow to the third pin 330 even when the SOF memory 110 is not biased. The isolation component 130 can also be configured to allow backflow currents when the SOF memory 110 is biased.

In the embodiment of Fig. 9, the isolation component 130 comprises a first transistor 131 called "first isolation transistor". Said first isolation transistor 131 has a channel and a gate. The channel is connected, on one side, to the second terminal 121 of the SOF memory 110, and, on the other side, to the third pin 330. Opening or blocking the channel of said first isolation transistor 131 respectively allows or blocks any current to flow. It means, it respectively allows or block the current flow from the second terminal 122 to the third pin 330 or from the third pin 330 to the second terminal 122. The gate of the first isolation transistor 131 controls the conductivity of the channel (the terms "open" and "close" have the same meaning as the ones used for the bias transistors 141, 142) to open or close the channel of the first isolation transistor 131 when the SOF memory 110 is, respectively, electrically biased or not. As shown in this example, the gate of said first isolation transistor 131 is connected to the bias circuit 140 in a way that the channel of the first isolation transistor 131 is only open, and respectively blocked otherwise, when the first bias transistor 141 is open. To do so, and as shown in the embodiment of Fig. 9, the gates of the first bias transistor 141 and the first isolation transistor 131 are connected together. They are also connected to the second pin 320 of the memory cell 100. This way, the first bias transistor 141 and the first isolation transistor 131 are controlled the same way.

As an embodiment, the gate of the first isolation transistor 131 can be connected to the bias circuit 140 in a way that the channel of the first isolation transistor 131 is only open, and respectively blocked otherwise, when the second bias transistor 142 is open. To do so, the gates of the second bias transistor 142 and the first isolation transistor 131 are connected together. They are are preferably connected to the second pin 320 of the memory cell 100. This way, the second bias transistor 142 and the first isolation transistor 131 are controlled the same way.

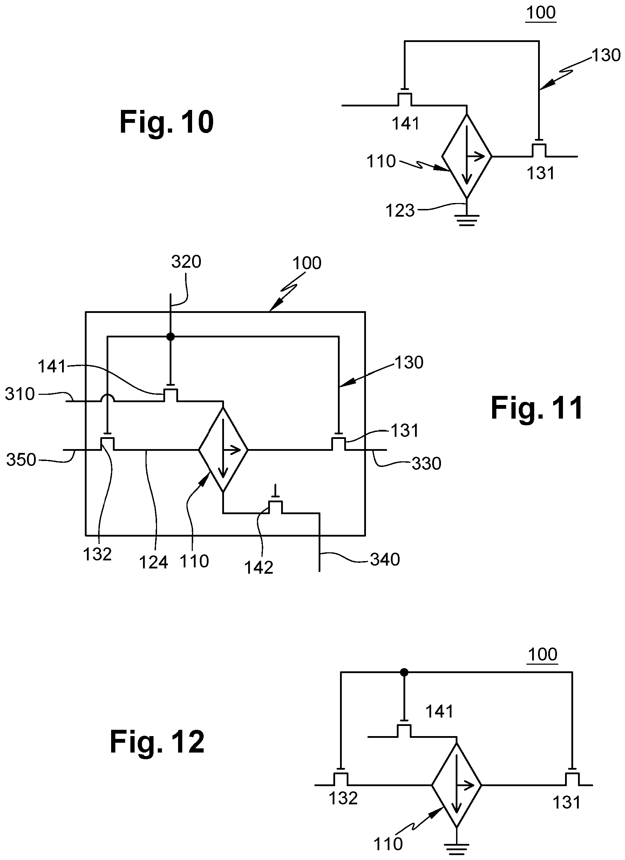

Fig. 10 shows an embodiment of the memory cell 100 (only the inner parts of the cell 100, the pins are not shown). It differs of the embodiment of Fig. 9 in that the second bias circuit 142 is missing. The third terminal 123 is directly connected to the ground. The memory cell 100 is simpler.

Fig. 11 shows an embodiment of the memory cell 100 that differs from the embodiments of Figs. 9 and 10 in that the SOF memory 110 comprises a fourth terminal 124. The SOF memory 110 corresponds for example to the one shown in Figs. 6 or 7. The memory cell 100 also comprises a fifth pin 350 that is intended to transmit signal from the fourth terminal 124 of the SOF memory 110.

The role of the isolation component 130 is to prevent electrical currents to flow from the fifth pin 350 to the SOF memory 110 that could erase the state stored in the SOF memory 110. To do so, the memory cell 100 is configured to isolate the fourth terminal when the SOF memory 110 is not biased. The isolation component 130 is therefore also connected between the fourth terminal 124 of the SOF memory 110 and the fifth pin 350. It is also configured to block any backflow currents coming from the fifth pin 350 when the SOF memory is not biased, and to allow current coming from the SOF memory 110 to flow to the fifth pin 350 when the SOF memory 110 is biased. This way, the SOF memory 110 is only connected to the third and fifth pins 330, 350 when it needs to.

In the embodiment of Fig. 11, the isolation component 130 comprises a second transistor 132 called "second isolation transistor". Said second isolation transistor 132 has, as the first isolation transistor 131, a channel and a gate. The channel is connected, on one side, to the fourth terminal 124 of the SOF memory 110, and, on the other side, to the fifth pin 350. Opening or blocking the channel of said second transistor 132 allows any current to flow from the fourth terminal 124 to the fifth pin 350 or from the fifth pin 350 to the fourth terminal 124. The gate of the second isolation transistor 132 controls the conductivity of the channel. To open or block the channel of the second isolation transistor 132 when the SOF memory 110 is, respectively, biased or not, the gate of said second isolation transistor 132 can be connected to the bias circuit 140 in a way that the channel of the second isolation transistor 132 is only open, and respectively blocked otherwise, when the first bias transistor 141 is open. In this example, and as for the first isolation transistor 131 of Fig. 9, the gates of the first bias transistor 141 and the second isolation transistor 132 are connected. Therefore, the gates of the first and second isolation transistors 131, 132 are connected together. The gates of the first and second isolation transistors 131, 132 can be connected to the second pin 320 of the memory cell 100. This way, the first bias transistor 141 and the first and second isolation transistors 131, 132 are controlled the same way.

As another embodiment, the gates of the second bias transistor 142 and the second isolation transistor 132 can be connected.

Fig. 12 shows an embodiment of the memory cell 100 that differs from Fig. 11 in that the second bias circuit 142 is missing, as in Fig. 10. The third terminal 123 is directly connected to the ground.

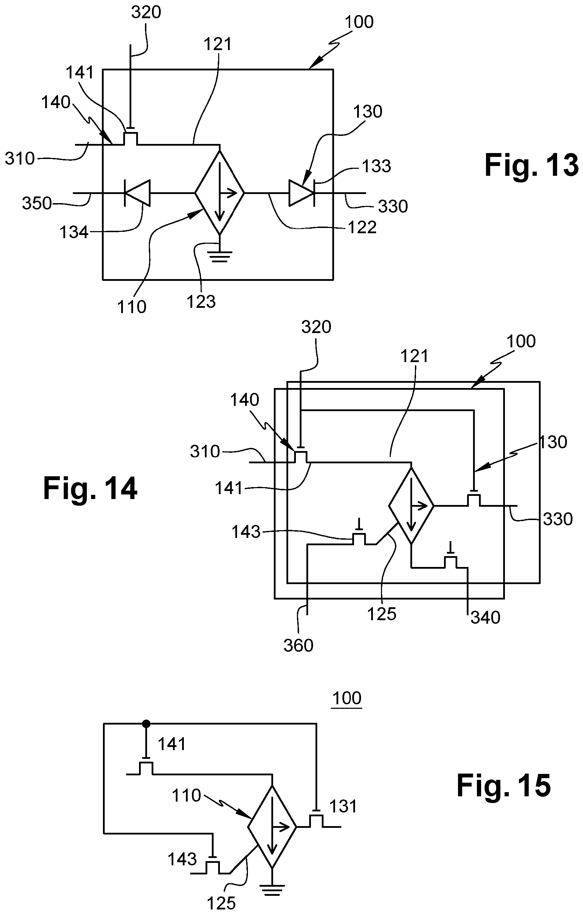

Fig. 13 shows another embodiment of the memory cell 100. In this embodiment, the SOF memory 110 comprises four terminals 121, 122, 123, 124. However, the isolation component 130 differs from the embodiments of Figs. 11 and 12 in that it does not rely on transistors to isolate the second and fourth terminals 122, 124 from the third and fifth pins 330, 350. It involves a first diode 133 and a second diode 134, respectively called "first isolation diode" and "second isolation diode". The role of the diodes is to block currents flowing from the pins 330, 350 towards the terminals 122, 124. The first and second diodes 133, 134 are, respectively, connected between the second terminal 122 and the third pin 330, and between the fourth terminal 124 and the fifth pin 350. The anodes of the isolation diodes 133, 135 are connected to, respectively, the second terminal 122 and the fourth terminal 124. Thus it only allows currents flowing from the SOF memory 110. It is a convenient way to implement the isolation component 130 as it does not need to be connected to the bias circuit 140.

This embodiment of the isolation component 130 is also compatible with a SOF memory 110 having a fourth terminal 124 missing, such as the ones of Figs. 2, 4, 6 and 8. Indeed, the sign of the first charge current I1 may not necessarily change. The spin-orbit effect that depends on the polarisation of the SOF memory 110 may only modify the amplitude of the voltage/current outputted by the second terminal 122. Therefore, only the second terminal 122 may be needed to perform a reading of the state of the polarisation of the SOF memory 110. Therefore, only the first isolation diode 133 is sufficient.

Fig. 14 show an embodiment of the memory cell 100 that differs from the previous embodiments that is involve a fifth terminal 125, also called "body contact" or "writing terminal". It is, for example, a SOF memory of Figs. 7 or 8, corresponding to a SOF memory of Figs. 3 or 4. The writing terminal 125 is involved in the writing of an information in the SOF memory 110. It can be control thanks to a voltage applied on a sixth pin 360. To drive correctly this writing terminal 360, the bias circuit 140 comprises a third transistor 143, called "writing transistor", that is connected between the writing terminal 125 and the sixth pin 360. The writing transistor 143 can be a FET or a bipolar transistor. It comprises a channel and a gate, controlling the conductivity of the channel. The channel is connected to the writing terminal 125 and the sixth pin 360. The gate of the writing transistor 143 controls the conductivity of the channel. When both the channel of the first bias transistor 141 and the channel of the writing transistor 143 are open (in other words when they are conductive), a voltage can be applied between the first and fifth terminals 121, 125. This voltage can generate an electrical field on the ferroelectric layer 116 of the SOF memory 110 to set the state of its spontaneous polarisation.

Fig. 15 shows a simplified view of an embodiment of the memory cell 100. This embodiment differs from the one of Fig. 14 in that the gate of the writing transistor 143 is connected to the gate of the first bias transistor 141. This way, both the first transistor 141 and writing transistor 143 can be open at a same time to apply a voltage between the first and fifth terminal 121, 125, to perform a writing operation.

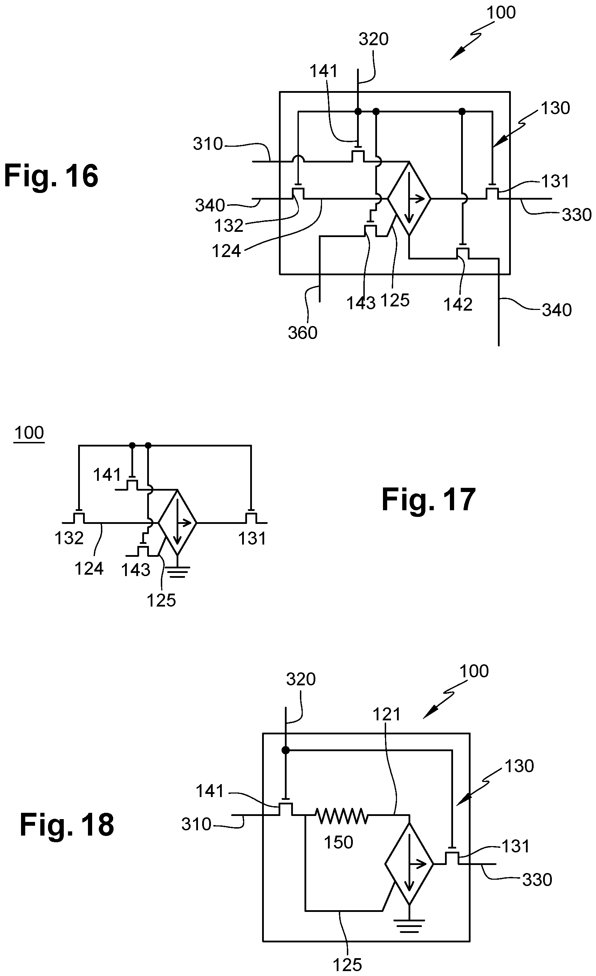

Fig. 16 shows an embodiment of the memory cell 100 that differs from the previous embodiment of Fig. 15 in that the SOF memory 110 comprises a fourth terminal 124. The SOF memory 110 corresponds, for example, to the memory of Fig. 3. The isolation component 130 further comprises a second isolation transistor 132 connected to the fourth terminal 124. The gates of the first and second bias transistors 141, 142, the gate of the writing transistor 143 and the gates of the first and second isolation transistors 131, 132 are connected together. This way, a unique command, for example applied on the second pin 320, can control both the reading and the writing operations of the memory cell 100. The writing can be performed using a voltage on the sixth pin 360 that is different from the voltage applied on the first pin. The reading can be performed using a voltage on the sixth pin 360 that is equal or close enough to the voltage applied on the first pin 310. By close enough, one means that their difference is inferior to 10%.

Fig. 17 shows a simplified view an embodiment of the memory cell 100 that differs from the embodiment of Fig. 16 in that the third terminal is connected to the ground.

Fig. 18 shows an embodiment of the memory cell 100 that differs from the embodiments of Figs. 14 to 17 in that the bias circuit 140 does not comprises a writing transistor 143. The writing terminal 125 is connected to the channel of the first bias transistor 141. The memory cell 100 further comprises a resistance 150 that is connected between the first bias transistor 141 and the first terminal 121. The resistance 150 induces a voltage drop between the first and fifth terminal 121, 125 when a voltage is applied on the first pin 310 (and the transistor is conductive). Indeed, the voltage drop across the ferroelectric layer of the SOF memory 110 depends on :
- the total resistance of the SOF memory 110 ;
- the resistance 150 ; and
- the voltage at the first terminal 121.
If the resistance 150 is properly designed (high enough), the corresponding electrical field between the first and fifth terminals 121, 125 is high enough to set the state of the polarisation of the SOF memory 110. For example, if the resistance of the SOF memory 110, between the first terminal 121 and the fifth terminal 125, is 10 kΩ and the coercive field of the ferroelectric layer (which is the field to overcome to commute the state of the SOF memory 110) is about 100 mV, the resistance 150 can be chosen to be 5 kΩ, and the input voltage at the first terminal 121 can be designed accordingly, for example 120 mV to read the state (inducing a voltage drop across the ferroelectric layer of 80 mV) and for example 180 mV to write the state (inducing a voltage drop across the ferroelectric layer of 120 mV).

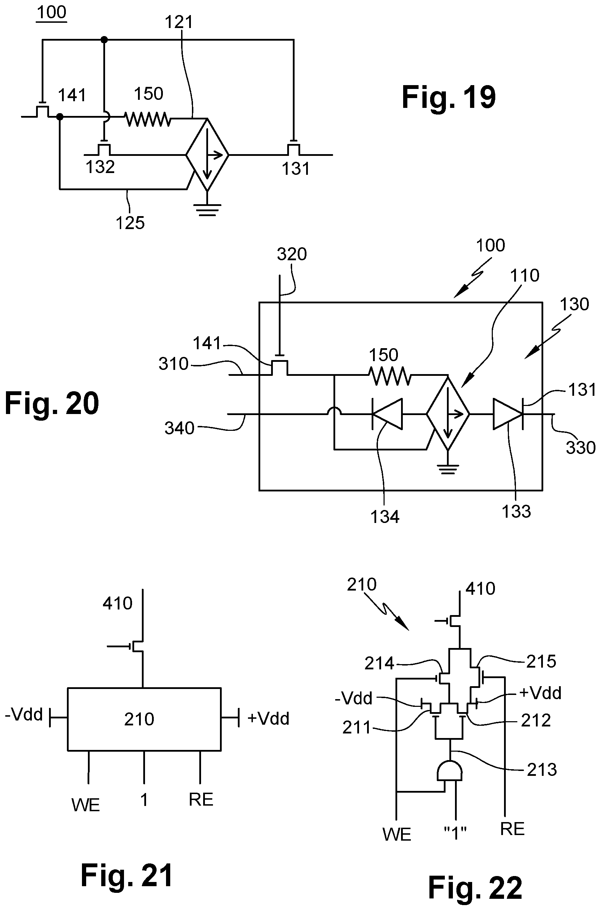

Fig. 19 shows an embodiment of the memory cell 100 that differs from the previous one of Fig. 18 in that the SOF memory 110 comprises a fourth terminal 124 and a second isolation transistor 132, The gate of the second isolation transistor 132 is connected to the gate of the first bias transistor 141.

Fig. 20 shows an embodiment of the memory cell 100 that differs from the one of Fig. 18 in that the isolation component 130 comprises diodes 133, 134 instead of transistors 131, 132.

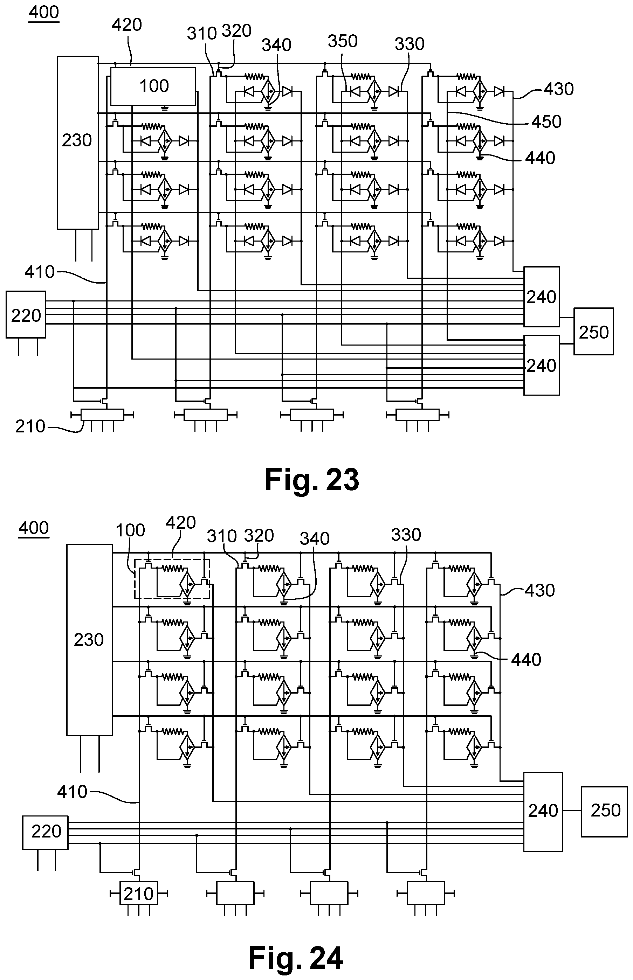

Fig. 23 shows a matrix 300 of memory cells 100 arranged in an array. In this example, the memory cells 100 comprises 5 contacting pins 310, 320, 330, 340, 350. Each cell 100 corresponds, for example, to a memory cell 100 according to Fig. 20. Specifically, the SOF memory in the cell 100 comprises two terminals 122, 124 to perform a reading operation.

The matrix 300 further comprises a plurality of first, second, third and fourth conducting lines 410, 420, 430, 450 respectively called "source lines", "word lines", "bit lines", and "complementary bit lines". The matrix 300 also comprise a fixed potential 440 forming a ground. Source and word lines 410 are allows to address and bias the cells 100. The bit lines 430 and complementary bit lines 450 allows to read an information stored in the memory cell 100 that is addressed and biased. The cells 100 are arranged in lines and columns. In Fig. 21, the cells 100 are arranged in four lines and four columns.

To address a memory cell 100, a voltage is applied to its second pin 320. To bias a memory cell 100, it has to be addressed and a voltage is applied to its first pin 310.

For each column of cells 100, the cells 100 of said column are connected to one of the source lines 410 by their first pin 310. For each line, the cells 100 of said line are connected to one of the word lines 420 by their second pin 320. All cells 100 are connected to the ground 440 by their fourth pin 340. Therefore, each cell 100 can be addressed and biased by selecting a specific word line 420 and a specific source line 410.

For each column, the cells 100 of said column are connected to one of the bit lines 430 and one of the complementary bit lines 450. Each cell is connected to a bit line 430 and a complementary bit line 450 by its third and fifth pins 330, 350. The isolation component 130 of each cell 100 is connected between the second terminal 122 of the SOF memory 110 and the bit line 430 and connected between the fourth terminal 124 of the SOF memory 110 and the complementary bit line 450. This way, cells 100 that are not addressed and biased will be isolated from the bit lines 430 and the complementary bit lines 450. Therefore, backflow currents flowing in a bit line 430 or in a complementary bit line 450 will not flow in a cell 100 if it is not addressed and not biased. Isolation circuit 130 prevent cells 100 to be erased if not addressed.

The matrix of Fig. 23 further comprises word decoder 230 and bit decoder 220. Each word line 420 is connected to the word decoder 230, while each source line 410 is connected to the bit decoder 220. The word decoder 230 and bit decoder 220 are configured to address each cell 110 needed at a certain stage of the computation. By addressing it is meant, to read or to write a data of a given memory cell 100.

The bit and word decoder 220, 230 are configured to address and biased a specific cell 100 using two binary numbers called "bit address" and "word address". The bit address (and respectively the word address) is decode by the bit decoder 220 (and respectively the word decoder 230) to apply a specific voltage on one of the source lines 310 (and respectively on one of the word lines 320). The decoders 220, 230 can be defined as logical gates having N inputs (with N being an integer) and 2·N outputs.

Writing and reading operations can be specific to the technology implemented in the memory cells 100. For memory cells 100 based on spin-orbit ferroelectric, the writing and reading operation can involve a specific write/read logic unit 210 (also called "W/R logic unit). In the embodiment of Fig. 23, the matrix 400 comprises a plurality of those W/R logic unit 210. Each source line 410 is connected to the bit decoder 220 using one of the W/R logic units 210. Each W/R logic unit 210 is configured to, on one hand, output a large enough voltage, positive or negative, to the source line 410 it is connected to, to write an information in a cell 100; and on the other hand, output a small enough voltage to the source line 410 it is connected to, to read the information stored in the cell 100. "High enough" and "small enough" voltages refer to high and low voltages discussed at Figs. 1 and 2.

Fig. 21 shows an example of a W/R logic unit 210. Fig. 22 shows a detailed implementation of such circuitry. The transistor shown between the W/R logic unit 210 and the source line 410 is a selector transistor that can be controlled by the bit decoder of Fig. 23. The W/R logic unit 210 is configured to output a current and controlling the sign of the current. Therefore, it is possible to write a "1" state or a "0" state depending on the current outputted and especially its sign. The W/R logic unit 210 can comprises a n-type transistor 211 and a p-type transistor 212. The drain of the n-type transistor 211 is connected to the source of the p-type transistor 212. The gates of the transistors 211, 212 are controlled by command 213, complementary to a "1" state. The sign of the output current is changed when the voltage applied on the "1" pin changes.

The W/R logic unit 210 can also comprises a first and a second additional transistors 214, 215 to select the operation to perform, such as writing or reading. Writing and, respectively reading, is selected using the "WE" pin, and respectively the "RE" pin. In this example, the drain of the first additional transistor 214 is connected to the drain of the n-type transistor 211 and to the source of the p-type transistor 212. Its gate is controlled by the "WE" pin. The drain of the second additional transistor 215 is connected to a positive voltage source and its gate is controlled by the "RE" pin.

Referring back to Fig. 23, the matrix 400 can further comprises at least one sense amplifier 250. The analogic signals coming from the bit lines 430 and the complementary bit lines 450 are read by a sense amplifier 250 and converted into a digital signal. In the embodiment of Fig. 23, the sense amplifier 250 is designed to convert analogic signals coming from both a bit line 430 and a complementary bit line 450.

The matrix 400 can comprises a plurality of sense amplifier 250, each one converting the signal coming from a couple of bit line 430 and complementary bit line 450. However, it can be more efficient to share only one sense amplifier 250 between multiple signals coming from the cells. To do so, the matrix of Fig. 23 comprises two multiplexers 240. The multiplexers 240 are connected to the bit lines 430 and complementary bit lines 450 to form a common bit line and common complementary bit line. Those common lines are inputted to the sense amplifier 250. The matrix 400 can also comprise a demultiplexer to demultiplex the digital signal of the sense amplifier 250.

The multiplexers 240 can take the bit lines 430, 450 as input as well as the source lines 410.

Fig. 24 shows an embodiment of a matrix 400 that differs from the matrix 400 of Fig. 23 in that it implements memory cells 100 having SOF memories 110 having only one output terminal. In this example, they correspond to memory cells 100 according to Fig. 18. Because there is only one output, the matrix 400 does not need complementary bit lines 450. It reduces the complexity of the matrix 400. The isolation component 130 of each memory cell 100 comprises one isolation transistor. The gate of the isolation transistor 131 of cells in a line can be connected directly to the word line 420 that connects said cells.

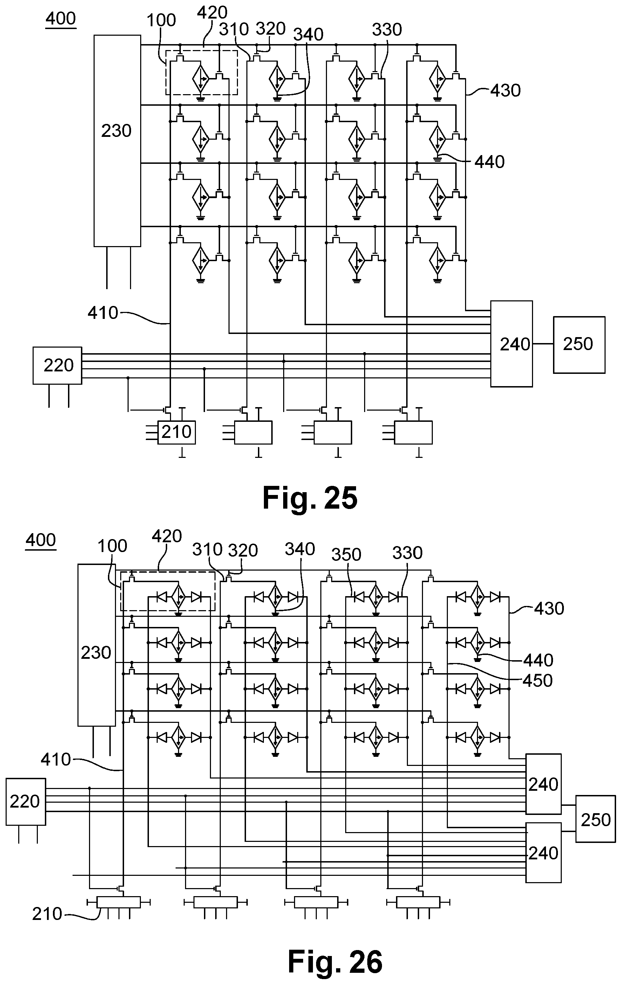

Fig. 25 shows an embodiment of a matrix 400 that differs from the matrix 400 of Fig. 24 in that it implements memory cells 100 according to Fig. 10.

Fig. 26 shows an embodiment of a matrix 400 that differs from the previous embodiments in that it implements memory cells 100 according to Fig. 13.

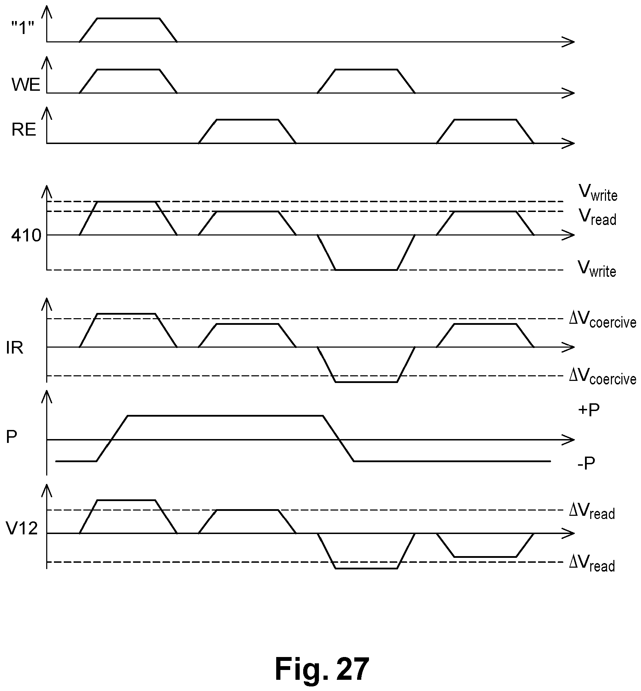

Fig. 27 shows an operation chronogram of the matrix 400 according to Fig. 24 when one of the cells 100 is selected. The matrix 400 can be operate as a non-volatile memory array. In this case, the cells 100 can be configured to store binary information. It means that the SOF memory 110 of each cell 100 should have a spontaneous polarisation that can adopt two stable states. In the example, the matrix is operated in order to write a high logical state "1" to a predetermined cell 100 (the cell considered in this example is never changed); to read the value stored; to write a low logical state "0"; and read the value stored.

The inputs WE and RE of the W/R logic unit 210 allows to select the operating mode : writing in or reading one of the cells. The input "1" of the W/R logic unit 201 allows to set the kind of information to store : high logical state or low logical state. A word address and bit address of the desired cell 100 need to be presented to the word decoder 230 and the bit decoder 220. However, as only one cell 100 is considered in this example, only the word and bit digits WS, BS corresponding to the cell 100 considered are shown. They are set to high state each time the cell 100 is accessed.

The voltage applied on the source line 410 is set to "Vwrite" to write a high logical state "1" and "-Vwrite" to write a low logical state "0". The voltage applied on the source line 410 is set to "Vread" to read the state stored. The Vread voltage is lower than the coercive voltage of the SOF memory 110. The Vwrite voltage is higher than this coercive voltage.

IR signal stands for the voltage applied on the ferroelectric layer of the SOF memory 110 of the cell 100. In the case of a SOF memory cell 110 as shown in Fig. 23, IR signal is proportional to the voltage between the first terminal 121 and the fifth terminal 125. In the case of a SOF memory cell 110 as shown in Figs. 25 or 26, IR signal is proportional to the voltage between the first terminal 121 and the third terminal 123.

The P signal stands for the state of the spontaneous polarisation of the SOF memory 110. +P and -P stands for two opposite directions.

The V12 signal stands for the transverse voltage that can be measured between the second and fourth terminal 122, 124 of the SOF memory 110. It corresponds to the voltage that can be measured between the bit line 430 and the complementary bit line 450. It allows to probe the state stored by the SOF memory 110.

A transverse voltage V12 value is generated when the SOF memory is biased. Therefore, even during a writing operation, a transverse voltage V12 is measurable. This transverse voltage V12 can be measured during the writing to check if the data to store in the cell 100 is well set correctly.

The matrix 400 can be operated for in-memory computing. This kind of computing consists in merging the memory and the processing stage in a single unit. It can be applied by simply addressing multiple cells 100 at once, and modifying the sense amplifier 250 such to have much output as cells 100 addressed. It allows to perform logical operation between cells 100 such as majority, sum, or material implication.

The matrix 400 can be operated for neuromorphic computing. Neuromorphic computing is based on key elements called "artificial neurons", each of them being represented by a cell 100 in the matrix. However, the cell 100 are configured to store an information that can be continuously modulated.

To do so, the memory cell 100 needs to be able to store a value that belongs to a continuum of values. The spontaneous polarisation of the SOF memory 110 can be able to adopt stable state among a plurality of distinctive stable states or even among a continuum of states. It can thereby encode a continuum of information state.

The outputs of an artificial neuron depend continuously to its input according to a coefficient, called "weight", represented by the information stored. The matrix 400 can be used for neuromorphic computing as it allows addressing multiple cells 100 at the same time, with different inputs. After a computation stage, an output is provided, that depends of the weights associated to each individual cell 100.

## Claims

1. Memory cell (100) comprising : a spin-orbit ferroelectric memory (110) comprising at least a first terminal (121), a second terminal (122), and a third terminal (123), the spin-orbit ferroelectric memory (110) having a spontaneous electrical polarisation being able to adopt at least two distinct states, the first, second, and third terminals (121, 122, 123) being connected to the spin-orbit ferroelectric memory in a way that a first charge current flows (11) in the second terminal (122) when a voltage is applied between the first and third terminals (121, 123), the amplitude and sign of the charge current being function of the voltage applied between the first and third terminals (121, 123) and function of the spontaneous electrical polarisation, the memory cell (100) being **characterized in that** it comprises an isolation component (130) connected to the second terminal (122) and configured to:
- prevent charge currents from flowing in the second terminal (122) towards the spin-orbit ferroelectric memory (110) when no voltage is applied between the first and third terminals (121, 123); and
- allow charge currents to flow in the second terminal and from the spin-orbit ferroelectric memory when a voltage is applied between the first and third terminals (121, 123).

2. Memory cell (100) according to claim 1, wherein the isolation component (130) comprises a diode (133) having an anode connected to the second terminal (122).

3. Memory cell (100) according to claim 1, wherein the isolation component (130) comprises a transistor (131) connected to the second terminal (122), said transistor (131) having a channel and a gate, said channel being connected to the second terminal (122) and said gate being connected to the first terminal (121) in a way to:
- block the channel of the transistor (131) of the isolation component (130) connected to the second terminal (122) when no voltage is applied between the first and third terminals (121, 123); and
- open the channel of the transistor (131) of the isolation component (130) connected to the second terminal (122) when the voltage is applied between the first and third terminals (121, 123).

4. Memory cell (100) according to any of claims 1 to 3, comprising a fourth terminal (124) connected to the spin-orbit ferroelectric memory in a way that a second charge current (12) flows in the fourth terminal (124) when a voltage is applied between the first and third terminals (121, 123), the amplitude and sign of the charge current being function of the voltage applied between the first and third terminals (121, 123) and function of the spontaneous electrical polarisation, the sign of the second charge current (12) being opposite to the sign of the first charge current (12), the isolation component being further configured to:
- prevent charge currents from flowing in the fourth terminal (124) towards the spin-orbit ferroelectric memory (110) when no voltage is applied between the first and third terminals (121, 123); and
- allow charge currents to flow in the fourth terminal (124) and from the spin-orbit ferroelectric memory (110) when the voltage is applied between the first and third terminals (121, 123).

5. Memory cell (100) according to claim 4, wherein the isolation component (140) comprises a diode (135) having an anode connected to the fourth terminal (124).

6. Memory cell (100) according to claim 4, wherein the isolation component (130) comprises a transistor (132) connected to the fourth terminal (124), said transistor (132) having a channel and a gate, said channel being connected to the fourth terminal (124) and said gate being connected to the first terminal (121) in a way to:
- block the channel of the transistor (132) of the isolation component (130) connected to the fourth terminal (124) when no voltage is applied between the first and third terminals (121, 123); and
- open the channel of the transistor (132) of the isolation component (130) connected to the fourth terminal (124) when a voltage is applied between the first and third terminals (121, 123).

7. Memory cell (100) according to any of claims 1 to 6, comprising a bias circuit (140) connected to the first and third terminals (121, 123), the bias circuit (140) comprising a transistor (141) having a channel and a gate, said channel being connected to the first terminal (121).

8. Memory cell (100) according to claim 3 and claim 7, wherein the gate of the transistor (141) of the bias circuit (140) is connected to the gate of the transistor (131) of the isolation component (130) connected to the second terminal (122).

9. Memory cell (100) according to claim 6 and claim 7, wherein the gate of the transistor (141) of the bias circuit (140) is connected to the gate of the transistor (132) of the isolation component (130) connected to the fourth terminal (124).

10. Memory cell (100) according to any of claims 1 to 9, wherein the spin-orbit ferroelectric memory (110) comprises a ferroelectric component (116), and the memory cell (100) comprises an additional terminal (125), the ferroelectric component (116) carrying the spontaneous electrical polarisation, the additional terminal (125) being connected to the spin-orbit ferroelectric memory (110) in a way that a voltage applied between the first terminal (121) and the fifth terminal (125) applies an electrical field on the ferroelectric component (116), the memory cell (100) further comprising a resistance (150) connected in parallel between the first terminal (121) and the fifth terminal (125).

11. Memory cell (100) according to any of claims 1 to 10, wherein the spin-orbit ferroelectric memory (110) comprises:
- a spin-orbit ferroelectric element, carrying the spontaneous electrical polarisation; and
- a spin polarisation element,
the spin polarisation element being connected between the first and third terminals (121, 123) and configured to generate a spin polarised current when the voltage is applied between the first and third terminals (121, 123), the spin-orbit ferroelectric element being connected between the second and third terminals (122, 123) and being configured to convert the spin polarised current issued from the spin polarisation element into the charge current flowing in the second terminal (122), the conversion being performed with a conversion rate and/or a conversion sign, said conversion rate and/or conversion sign being function of the spontaneous electrical polarisation.

12. Memory cell (100) according to claim 11, wherein the spin-orbit ferroelectric element comprises:
- a ferroelectric layer carrying the spontaneous electrical polarisation; and
- a spin-orbit layer in direct contact with the ferroelectric layer.

13. Matrix (400) **characterised in that** it comprises a plurality of memory cells (100) according to any of claims 1 to 12.

14. Matrix (400) according to claim 13, further comprising:
- a plurality of first conducting lines (410), called "source lines";
- a plurality of second conducting lines (420), called "word lines"; and
- a plurality of third conducting lines (430), called "bit lines",
each memory cell (100) being connected to a source line (410) of the plurality of source lines, a word line (420) of the plurality of word lines, and a bit line (430) of the plurality of bit lines, for each memory cell (100), the isolation component (130) of said memory cell (100) is connected between the second terminal (122) of said memory cell (100) and the bit line (430) connected to said memory cell (100).

15. Matrix (400) according to claim 14, wherein each memory cell (100) is a memory cell (100) according to any of claims 7 to 9, and wherein, for each memory cell (100), the channel of the transistor (141) of the bias circuit (140) of said memory cell (100) is connected to the source line (310) connected to said memory cell (100), and the gate of the transistor (141) of the bias circuit (140) of said memory cell (100) is connected to the word line (320) connected to said memory cell (100).

16. Matrix (400) according to any of claims 14 or 15, further comprising a plurality of fourth conducting lines (340), called "complementary bit lines", and wherein each memory cell (100) is a memory cell (100) according to claims 4 to 6 or to claim 9, and wherein, for each memory cell (100), the fourth terminal (124) of said memory cell (100) is connected to a complementary bit line (340) of the plurality of complementary bit lines, and wherein, for each memory cell (100), the isolation component (130) of said memory cell (100) is connected between the fourth terminal (124) of said memory cell (100) and the complementary bit line (340) connected to said memory cell (100).
